Europäisches Patentamt

European Patent Office

Office européen des brevets

(11) Veröffentlichungsnummer : **0 501 169 B1**

(12) **EUROPÄISCHE PATENTSCHRIFT**

(45) Veröffentlichungstag der Patentschrift :
**23.08.95 Patentblatt 95/34**

(51) Int. Cl.[6] : **G01R 29/08**

(21) Anmeldenummer : **92101674.7**

(22) Anmeldetag : **01.02.92**

(54) **Feldstärkenmessgerät.**

(30) Priorität : **25.02.91 CH 563/91**

(43) Veröffentlichungstag der Anmeldung :
**02.09.92 Patentblatt 92/36**

(45) Bekanntmachung des Hinweises auf die
Patenterteilung :
**23.08.95 Patentblatt 95/34**

(84) Benannte Vertragsstaaten :
**CH DE FR GB IT LI**

(56) Entgegenhaltungen :
**US-A- 4 277 744**
**US-A- 4 328 461**

(56) Entgegenhaltungen :
**IEEE TRANSACTIONS ON INSTRUMENTA-**
**TION AND MEASUREMENT Bd. IM-32, Nr. 4,**
**Dezember 1983, Seiten 466 - 468; KLAUS MU-**
**̈NTER: 'an isolated sensor determining the**
**poyntning vector in the near field of a radia-**
**ting antenna'**
**5TH IEEE PULSED POWER CONFERENCE 10.**
**Juni 1985, Seiten 381 - 384; A. KÜCHLER,**
**J. DAMS, TH. DUNZ, A.J. SCHWAB: 'combined**
**e- and h- field probe for traveling wave analy-**
**sis in pulse power generators'**

(73) Patentinhaber : **ASEA BROWN BOVERI AG**
**Haselstrasse 16**
**CH-5401 Baden (CH)**

(72) Erfinder : **Gassmann, Felix**
**Etzelweg 65**
**CH-8038 Zürich (CH)**

## Beschreibung

## Technisches Gebiet

Die Erfindung betrifft ein Feldstärkenmessgerät mit einer zum gleichzeitigen Detektieren von E- und H-Feldern geeigneten Schleifenantenne, welche durch zwei an gegenüberliegenden Seiten der Schleifenantenne angeordnete Lastwiderstände in eine erste und eine zweite Halbschleife aufgetrennt ist, und mit einer Schaltung zum Ermitteln der Feldstärken der E- und H-Felder anhand der an den Lastwiderständen gemessenen Spannungen.

## Stand der Technik

In grosser Entfernung von der Strahlungsquelle sind elektromagnetische Felder verhältnismässig einfach zu bestimmen. Für die Beurteilung der elektromagnetischen Kompatibilität (EMC) und der biologischen Auswirkungen ist dagegen die Kenntnis der Nahfelder der zu untersuchenden Strahlungsquelle von weit grösserer Bedeutung. Diese Felder enthalten nämlich mit viel grösserer Wahrscheinlichkeit unzulässige Feldstärkenmaxima. Sie zeichnen sich aber auch aus durch höchst komplizierte Feldstrukturen mit sowohl stehenden als auch propagierenden Wellen, unregelmässigen Phasenflächen u. dgl. Bei solchen Feldern ist der Poynting Vektor nicht direkt ableitbar aus der Grösse des elektrischen oder magnetischen Feldes allein.

Generell wird angenommen, dass die Störempfindlichkeit von Geräten gegenüber elektromagnetischen Feldern oder die Möglichkeit biologischer Schädlichkeit abhängig von der auftretenden Feldstärke ist. Beispielsweise sind die Erwärmung verlustbehafteter Dielektrika (z.B. menschlicher Gewebe) und die damit verbundene Schädigungsgefahr proportional zum zeitlichen Mittelwert des Betrags der elektrischen Feldstärke im Quadrat. In ähnlicher Weise ist die Erwärmung partiell leitender Materialien proportional zum zeitlichen Mittelwert des Betrags der magnetischen Feldstärke im Quadrat.

Da die konventionellen Feldstärkenmessgeräte mit verhältnismässig richtungsempflindlichen Antennen arbeiten, können die komplizierten Nahfelder nicht zuverlässig gemessen werden. Ausserdem sind diese Messgeräte darauf beschränkt, entweder nur das E- oder nur das H-Feld zu messen, was aus den erwähnten Gründen zur Charakterisierung von Nahfeldern nicht ausreicht.

Ein sehr aufwendiges, aktives Sensorsystem, das für Nahfeldmessungen im Prinzip geeignet ist, ist aus dem Artikel "An isolated sensor determining the Poynting vector in the near field of ratiation antenna", Klaus Münter, IEEE Trans. on Instr. and Measurement, Vol. IM-32, No. 4, Dec 1983, bekannt. Ein Messkopf umfasst Dipole und Magnetschleifen für alle drei Ebenen (x, y, z). Die insgesamt sechs Signale (drei Dipole, drei Magnetschleifen) werden parallel verstärkt und mit sechs parallelen Mischern auf eine Zwischenfrequenz von 100 kHz gebracht. Ein 1-aus-6-Multiplexer schaltet die Signale seriell auf einen ebenso integrierten Optolink. Ein Steuergerät empfängt die optische Information und leitet die Signale an einen Vektor-Analysator weiter. Mittels eines Rechners können dann E- und H-Vektor und damit auch der Poynting-Vektor räumlich dargestellt werden.

Das soeben beschriebene System arbeitet bei Frequenzen von 500 kHz bis 10 MHz und erreicht eine Empfindlichkeit von 0.2 V/m und 500 mA/m. Die obere Grenze liegt bei 50 V/m. Bei höheren Feldstärken wurden Störungen im Rechnersystem beobachtet. Da dieses System die Felder nur schmalbandig verarbeitet, muss die zu messende Frequenz bekannt sein. Ein gleichzeitiges Messen von zwei überlagerten Feldern ist hier nicht möglich.

Ein breitbandiges System zum gleichzeitigen Messen von E- und H-Feldkomponenten unter Nahfeldbedingungen ist in der Veröffentlichung "An electromagnetic near-field sensor for simultaneous electric and magnetic-field measurements", Motohisa Kanda, IEEE Trans. on Electromagnetic Compatibility, Vol EMC-26, No. 3, August 1984, beschrieben. Als Sensor wird eine Schleifenantenne verwendet, die an zwei diametral gegenüberliegenden Seiten durch zwei identische Lastwiderstände aufgetrennt ist. Zur Bestimmung einer durch die Antennenorientierung vorgegebenen Komponente des E- resp. H-Feldes werden die Spannungen an den beiden Lastwiderständen gemessen. Um die beiden Spannungen gleichzeitig messen zu können, ohne irgendwelche messtechnisch störenden Schleifen einzuführen, ist die Antenne in der Art eines dicken rechteckigen Rahmens ausgeführt, in dessen rohrförmigem Innern die Messelektronik untergebracht ist.

Die Vorrichtung von Kanda erlaubt zwar die Messung beliebig überlagerter Felder, ist aber aus konstruktiven Gründen auf die Messung einer vorgegebener Richtungskomponente des E- resp. H-Feldes beschränkt. Es können also nicht alle drei Komponenten der Feldvektoren gleichzeitig gemessen werden. Ausserdem ist sie ziemlich gross und unhandlich.

## Darstellung der Erfindung

Aufgabe der Erfindung ist es, ein Feldstärkenmessgerät der eingangs genannten Art anzugeben, das breitbandig misst und klein und handlich ist.

Erfindungsgemäss besteht die Lösung darin, dass bei einem Feldstärkenmessgerät der eingangs genannten Art die erste Halbschleife beidseitig durch eine Metallfläche hindurchgeführt ist und über Lastwiderstände an die Metallfläche angeschlossen ist, so dass die erste Halbschleife mit ihrem feldtheoretisch durch die Metallfläche erzeugten, die zweite Halbschleife ersetzenden Spiegelbild eine geschlossene Schleifenantenne bildet, und dass die Schaltung in einem durch die Metallfläche gegenüber der ersten Halbschleife abgeschirmten Teilraum angeordnet ist.

Der Vorteil der erfindungsgemässen Anordnung besteht darin, dass die Spannungen an den beiden Lastwiderständen gleichzeitig gemessen werden können, ohne dass durch die für das Abgreifen der Spannung benötigten elektrischen Leiter und die Messelektronik störende Induktionsschleifen gebildet werden. Gleichzeitig wird ausserdem die Schaltung selbst durch die Metallfläche abgeschirmt und läuft damit nicht Gefahr, vom elektromagnetischen Feld beeinträchtigt oder zerstört zu werden. Sie kann auch das zu messende Feld in keiner Weise störend beeinflussen.

Wenn die Metallfläche eine gekrümmte, in sich geschlossene Fläche bildet, die den abgeschirmten Teilraum allseitig umschliesst, dann stellt das erfindungsgemässe Feldstärkenmessgerät eine mobiles und handliches Testgerät dar, das z.B. zum Messen von elektromagnetischen Feldern in der Nähe von Rundfunksendeanlagen geeignet ist.

Um eine optimale Detektion zu gewährleisten, sollte die erste Halbschleife im wesentlichen einen Teilabschnitt (insbesondere die Hälfte) eines Kreises resp. eines regulären Polygons bilden.

Besonders vorteilhaft ist es, wenn die zwei Lastwiderstände im wesentlichen gleich gross sind und zwischen 50 und 1000 Ohm, insbesondere zwischen 100 und 300 Ohm liegen, da dann die zu messenden Spannungen in der gleichen Grössenordnung liegen. Messtechnisch ist die Verarbeitung der Spannungen nämlich besonders problemlos, wenn sie sich um weniger als eine Dekade unterscheiden.

Zur Kompensation der induktiven Charakteristik der Schleifenantenne ist zum Abgreifen einer an einem Lastwiderstand anliegenden Spannung jeweils ein Tiefpass erster Ordnung mit einem gegenüber dem Lastwiderstand grossen Eingangswiderstand und einem in mehrere parallele Teilkapazitäten aufgeteilten C-Glied vorgesehen.

Zur Realisierung eines besonders bevorzugten, dreidimensionalen, isotropen Feldstärkenmessgeräts ist die Metallfläche als Kugelfläche ausgebildet ist und weist drei paarweise orthogonal ausgerichtete gleiche Halbschleifen auf, derart dass E- und H-Feld gleichzeitig vektoriell bestimmt werden können.

Um im ganzen Frequenzbereich einen linearen Frequenzgang sicherstellen zu können, sollten die Halbschleifen je eine Fläche einschliessen, die nicht grösser als der halbe Wirkungsquerschnitt der Kugeloberfläche ist. Ausserdem sollte der Kugeldurchmesser kleiner als die Hälfte, insbesondere kleiner oder gleich einem Zehntel der kleinsten zu messenden Wellenlänge des E- resp. H-Feldes sein.

Gemäss einer besonders einfachen und leichten Ausführungsform ist die erste Halbschleife ein drahtförmiges Gebilde mit einem Durchmesser von mehr als 0.1 mm, insbesondere von mindestens 1 mm.

Eine stabile Konstruktion ergibt sich, wenn die erste Halbschleife eine auf eine isolierende Leiterplatte aufgebrachte Leiterbahn ist.

Besonders vorteilhaft, weil gut simulierbar und entsprechend einfach bemessbar (im Hinblick auf die gewünschten Signalpegel) ist eine erste Halbschleife in der Form einer Hälfte eines Quadrats.

Aus der Gesamtheit der abhängigen Patentansprüche, insbesondere aus geeigneten Kombinationen der einzelnen oben genannten Merkmalen ergeben sich weitere vorteilhafte Ausführungsformen.

## Kurze Beschreibung der Zeichnungen

Nachfolgend soll die Erfindung anhand von Ausführungsbeispielen und im Zusammenhang mit den Zeichnungen näher erläutert werden. Es zeigen:

Fig. 1a,b     das Prinzip der erfindungsgemässen Schleifenantenne;

Fig. 2     eine schematische Darstellung des kugelförmigen Feldstärkenmessgeräts;

Fig. 3     ein Tiefpass erster Ordnung zum Abgreifen der am Lastwiderstand anliegenden Spannung;

Fig. 4     eine schematische Darstellung der dreidimensionalen Ausführungsform; und

Fig. 5     eine schematische Darstellung einer Halbschleife in der Form einer aufgedruckten Leiterbahn.

Die in den Zeichnungen verwendeten Bezugszeichen und deren Bedeutung sind in der Bezeichnungsliste zusammenfassend aufgelistet. Grundsätzlich sind in den Figuren gleiche Teile mit gleichen Bezugszeichen versehen.

EP 0 501 169 B1

**Wege zur Ausführung der Erfindung**

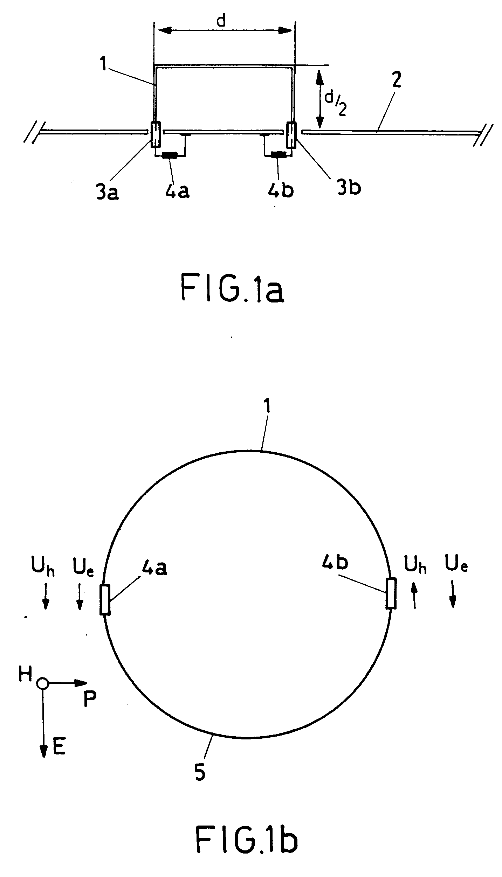

Anhand der Fig. 1a, b soll zunächst das Prinzip der Erfindung erläutert werden. Fig. 1a zeigt die erfindungsgemässe Schleifenantenne. Sie umfasst eine erste, bügelförmige Halbschleife 1, die von einer Metallfläche 2 abgeschlossen wird. Die beiden Enden der Halbschleife 1 sind durch die Metallfläche 2 hindurchgeführt (Koaxialdurchführungen 3a, 3b) und mittels zwei Lastwiderständen 4a, 4b an die Metallfläche 2 angeschlossen. Die Metallfläche 2 kann vom Prinzip her als eine unendliche Ebene betrachtet werden, die den Raum in zwei Teilräume aufteilt. Der sog. Aussenraum ist der Teilraum, in dem das zu messende elektromagnetische Feld und damit auch die erste Halbschleife 1 ist. Der sog. Innenraum ist der zweite, durch die Metallfläche gegenüber dem zu messenden Feld abgeschirmte Teilraum.

Feldtheoretisch gesehen spiegelt die Metallfläche 2 die erste Halbschleife 1 und simuliert damit gewissermassen eine zweite Halbschleife 5 (Fig. 1b). Die erste Halbschleife 1 und ihr Spiegelbild bilden zusammen eine geschlossene Schleifenantenne, die elektromagnetisch aequivalent zu der in Fig. 1b dargestellten ist. Das Prinzip dieser Schleifenantenne besteht darin, dass es durch das Einfügen der beiden Lastwiderstände 4a, 4b gelingt, den elektrischen Einfluss vom magnetischen vollständig und definiert zu trennen.

Die Trennung der Einflüsse lässt sich für den Fall eines idealen, transversalen elektromagnetischen Feldes (ebene Welle) auf anschauliche Weise zeigen. Das E-Feld soll dabei parallel zur Ebene der Schleifenantenne (Zeichenebene) liegen und zwar senkrecht zu dem die beiden diametral gegenüberliebenden Lastwiderstände 4a, 4b verbindenden Druchmesser. Das H-Feld soll senkrecht zum E-Feld und senkrecht zur Ebene der Schleifenantenne (also senkrecht zur Zeichenebene) stehen. Der Poynting-Vektor ist damit parallel zu dem die beiden diametral gegenüberliebenden Lastwiderstände 4a, 4b verbindenden Druchmesser der Schleifenantenne.

Die beschriebenen Richtungen sind in der Fig. 1b in üblicher Notation eingezeichnet. E bezeichnet die Komponente des elektrischen Feldes, H diejenige des magnetischen und P bezeichnet den Poynting-Vektor ($P = E \times H$).

Dem durch das H-Feld induzierten Kreisstrom (der an den Lastwiderständen zu einer Spannung $U_h$ führt) wird eine Spannung $U_e$ überlagert, die aus dem sog. Dipolmodus der Schleifenantenne entsteht. Aufgrund der symmetrischen Anordnung der (reellen) Lastwiderstände 4a, 4b addieren sich beim einen Lastwiderstand 4a die beiden Spannungen $U_e$ und $U_h$ zu einer Spannung $V_1$, während sie sich am anderen voneinander subtrahieren zu einer Spannung $V_2$. Für diesen einfachen Fall ist somit klar, dass sich die Einflüsse von E- und H-Feld voneinander trennen lassen.

Um die Funktion des Prinzips für alle auftretenden Fälle, insbesondere bei Nahfeld-Bedingungen zu beweisen, müssen die Sensorspannungen aber auf allgemeine Art berechnet werden. Dies wurde auch gemacht und es konnte auf analytischem Weg gezeigt werden, dass die dargelegten Ueberlegungen im Endeffekt auch für eine beliebig polarisierte Welle, die aus beliebiger Richtung auf die Schleifenantenne trifft, gelten: Die Summe der über den beiden Lasten gebildeten Spannungen hängt nur vom Grundmodus, d.h. von der magnetischen Feldkomponente, die Differenz hingegen nur vom Dipolmodus und somit von der elektrischen Feldkomponente ab.

Um den quantitativen Einfluss der E- und H-Felder auf die Schleifenantenne abschätzen zu können, wurden numerische Berechnungen durchgeführt. Die Rechnungen basierten auf einer quadratischen Schleife mit einer Kantenlänge von 10 cm und einem Drahtdurchmesser von 1 mm.

Als erstes zeigten die Berechnungen im Frequenzbereich 1 bis 100 MHz, dass die Spannungen $V_1$, $V_2$ an den Lastwiederständen mit 20 dB pro Dekade ansteigen und sich damit frequenzmässig induktiv ersten Grades verhalten. Eine Abflachung des idealen Anstieges trat bei etwa 30 MHz ein, d.h. dann wenn die Antenne nicht mehr als elektrisch kurz ($\mu$ 1/10 der Wellenlänge) anzunähern ist. Die Signalspannungen bewegten sich bei 1 MHz im Bereich 1 mV und bei 100 kHz nur noch im Bereich 100 $\mu$V. Vergrössert man die Dimension der Schleife, so steigen zwar die Signalspannungen im Gesamten an, aber der Frequenzgang beginnt in unerwünschter Weise schon bei tieferen Frequenzen abzuflachen.

Bei den Berechnungen wurden auch die Lastwiderstände variiert. Es konnte festgestellt werden, dass bei den geometrischen Parametern des vorliegenden Rechnungsbeispiels zwischen 50 und 200 Ohm ein kritischer Wert für die Last existiert, bei welchem die Summe und die Differenz der Spannungen $V_1$ und $V_2$ etwa gleich gross sind. Weitere Berechnungen haben gezeigt, dass der Wert der kritischen Last von den Dimensionen der Schleife abhängt und im linearen Frequenzbereich einigermassen konstant bleibt. Damit lässt sich also die magnetische und die elektrische Signalantwort des Sensors durch die Wahl der Last zielgerichtet beeinflussen.

Aufgrund der Berechnungen sind die Verhältnisse bei Lastwiderständen von etwa 1000 Ohm günstig. Die Signalpegel liegen etwa im gleichen Bereich (d.h. sie unterscheiden sich um weniger als 1 Dekade), wobei die minimale Signalspannung (bei 75 kHz und 10 V/m) grösser ist als bei den anderen Lastwiderstandswerten.

4

EP 0 501 169 B1

In der Praxis dürften aber solch hochohmige Abschlüsse aufgrund der Streukapazitäten nicht das Optimum bilden. Besonders bevorzugt werden deshalb Widerstandswerte im Bereich von 100 - 300 Ohm.

Während die oben erwähnte analytische Beweisführung auf der Basis einer kreisförmigen Schleifenantenne gemacht wurden, beruhten die obigen quantitativen Berechnungen (der Einfachheit halber) auf einer quadratischen Schleifenform. Das Quadrat wurde dabei als einfachste Annäherung an den Kreis betrachtet. Bei symmetrischen, d.h. polygonalen Schleifen hat es sich aber gezeigt, dass die Form qualitativ keinen, quantitativ aber nur einen vernachlässigbar kleinen Einfluss auf die Spannungsverläufe hat.

In bezug auf die Symmetrie resp. die Form der Schleife ist zu beachten, dass der Einfluss des H-Feldes von der Fläche und derjenige des E-Feldes von der "Höhe" der Schleife abhängt. Unter "Höhe" ist dabei die Länge der Projektion der Schleife auf eine zum E-Feld (gemäss Fig. 1b) parallele Gerade zu verstehen. Wenn die Schleife alse stark asymmetrisch ist (d.h. wenn sie z.B. die Form eines langen, schmalen Rechtecks hat) dann geht die gewünschte Linearität im Frequenzgang der Spannungen $V_1$, $V_2$ verloren.

Grundsätzlich kommt man mit der Schleifenantenne an die Grenze ihrer Fähigkeiten, wenn die Krümmung der Wellenfront gegenüber dem Schleifendurchmesser nicht mehr vernachlässigbar ist. Speziell für Nahfeldmessungen ist es deshalb wichtig, die Ausdehnung des Sensors möglichst klein zu halten. Damit erhält man eine quasi punktförmige Feldinformation und unterdrückt den Einfluss der Wellenfrontkrümmung. Für einen Frequenzbereich von 75 kHz bis 30 MHz empfiehlt es sich deshalb, den äquivalenten Schleifendurchmesser nicht grösser als 10 cm zu wählen.

Die analytischen und numerischen Berechnungen wurden auf der Basis der äquivalenten Schleifenantenne gemäss Fig. 1b durchgeführt. Sie gelten aber aus feldtheoretischen Gründen auch für die erfindungsgemässe Ausführungsform (Fig. 1a) mit der abschliessenden Metallfläche. Für den idealen Fall der unendlich grossen, ebenen Metallfläche können die Resultate sogar direkt übernommen werden. Für den bevorzugten Fall einer gekrümmten, in sich geschlossenen Fläche ist die Gültigkeit zu beweisen. Dies wurde am Beispiel der kugelförmigen Metallfläche auch getan.

Aufgrund der Komplexität der Abhängigkeiten zwischen Schleifengeometrie und Feldeinflüssen ist es aber nicht möglich, die oben diskutierten Zusammenhänge ohne weiteres aufzudecken. Es konnte aber festgestellt werden, dass bei geeignet gewähltem Kugeldurchmesser (< 1/2 der Wellenlänge) keine stehenden Wellen auf der Oberfläche auftreten. Die durch die gekrümmte Metallfläche bedingten niedrigeren Signalpegel stellen kein grundsätzliches Problem dar, da sie durch Vergrössern der Schleifengeometrie (insbesondere der Schleifenfläche) wieder angehoben werden können.

Um eine punktförmige Feldinformation zu erhalten, sollte die Kugel möglichst klein sein. Andererseits sollte die Halbschleife gegenüber der Kugel nicht zu gross sein, aber trotzdem zu detektierbaren Spannungsamplituden führen. Aus diesen Ueberlegungen empfiehlt es sich, die Halbschleife von der eingeschlossenen Fläche her so zu bemessen, dass sie nicht grösser als der halbe Wirkungsquerschnitt der Kugeloberfläche ist. Die eigentliche Schleifenantenne, die im Prinzip aus der Halbschleife und ihrem Spiegelbild besteht, hat also etwa den gleichen Wirkungsquerschnitt wie die Kugel.

Im folgenden wird eine besonders bevorzugte Ausführungsform der Erfindung beschrieben.

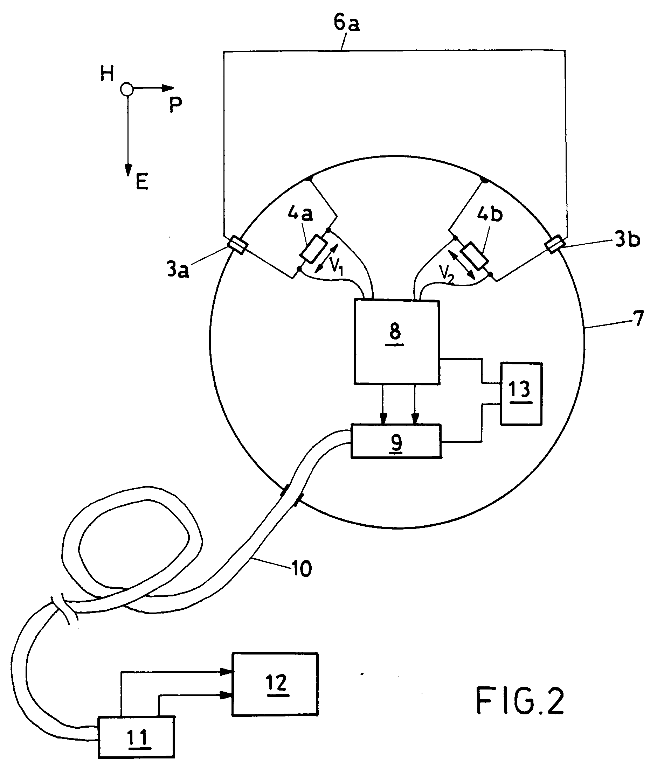

Fig. 2 zeigt ein Feldstärkenmessgerät, das sich insbesondere für dreidimensionale Feldmessungen eignet. Der Einfachheit halber ist aber nur eine Schleifenantenne gezeigt. Diese wird durch eine Halbschleife 6a und eine Kugel 7 gebildet. Die Halbschleife 6a besteht vorzugsweise aus einem ca. 1 - 2 mm starken Kupferdraht, der ein halbes Quadrat bildet. Sie weist also eine Längsseite und zwei Kurzseiten auf, wobei die Längsseite etwa doppelt so lang ist wie eine Kurzseite. Die Schleifenantenne detektiert diejenige Komponente des E-Feldes, die parallel zu den Kurzseiten ist. Zugleich wird auch die Komponente des H-Feldes ermittelt, die senkrecht zu der durch die Halbschleife 6a definierte Ebene (im vorliegenden Fall also senkrecht zur Zeichenebene) steht. Die Orientierung der relevanten Komponenten ist in Fig. 2 (oben links) in gebräuchlicher Art dargestellt.

Der Kupferdraht der Halbschleife ist an zwei, (bezüglich der äquivalenten Vollschleife) im wesentlichen diametral gegenüberliegenden Stellen durch die Kugel 7 isoliert hindurchgeführt. Schliesslich ist der Kupferdraht über je einen Lastwiderstand 4a, 4b an die Innenseite der Kugel 7 angeschlossen (angelötet).

Die Koaxialdurchführungen 3a, 3b sollten vorzugsweise etwa die selbe Impedanz wie die Lastwiderstände 4a, 4b haben. Die Impedanz einer Koaxialleitung ergibt sich bekanntlich aus der Beziehung:

$$(I) \qquad z_{koax} = \frac{60}{\ddot{Y}_r} \ \ln \frac{d_a}{d_i}$$

$d_a$ = Innendurchmesser des Aussenleiters (Schirm)
$d_i$ = Aussendurchmesser des Innenleiters (Kupferdraht)

$\ddot{Y}_r$ = relative Dielektrizitätskonstante

Wenn aber der Durchmesser des Kupferdrahts 2 mm, der Lastwiderstand 200 Ohm und die Dielektrizitätskonstante $\ddot{Y}_r$ = 2 (Teflon) ist, müsste für eine angepasste Impedanz $Z_{koax}$ der Innendurchmesser $d_a$ ca. 22 cm betragen. Dies ist für die vorliegende Anwendung ein zu grosser Wert.

Aus diesem Grund wurden Berechnungen durchgeführt, die zum Ziel hatten, den Fehler abzuschätzen, der entsteht, wenn bei Lastwiderständen im bevorzugten Bereich von 50 - 1000 Ohm gut erhältliche 50 Ohm Koaxialdurchführungen verwendet werden. Die Auswertung der Berechnungen führte zur Erkenntnis, dass auch bei Durchführungslängen von 5 cm (denkbar ungünstigster Fall) die Transformation der Lastimpedanz an den (äusseren) Eingang der Koaxialdurchführung gering ist. Bei Lastwiderständen bis zu 200 Ohm kann der untersuchte Effekt sogar vernachlässigt werden. Der störende Effekt reduziert sich entsprechend bei praxisnahen Durchführungslängen von 1 cm.

Zur weiteren Beschreibung nun wieder zurück zu Fig. 2. Die an den beiden Lastwiderständen 4a, 4b anliegenden Spannungen $V_1$, $V_2$ werden abgegriffen und von einer elektronischen Schaltung 8 z.B. zu digitalen Signalen aufbereitet. Diese werden über eine an sich bekannte optische Uebertragungsstrecke (sog. Optolink), umfassend einen Sender 9a, ein Glasfaserkabel 10 und einen Empfänger 11, zu einem Messrechner 12 geschickt.

Die Schaltung 8 sollte so klein wie möglich sein und nur die für die Uebertragung notwendige Signalaufbereitung durchführen. Die minimale Grösse des Innenraums der Kugel ist gewissermassen bestimmt durch die für die Aufbereitung und Uebertragung in der Kugel benötigte Energie. Denn die Energie muss durch einen netzunabhängigen Akkumulator 13 zur Verfügung gestellt werden, der in der Kugel selbst untergebracht sein muss und dessen Volumen von der Grösse der Versorgungsleistung abhängt.

Der wesentliche Punkt beim Optolink und beim Akkumulator liegt darin, dass die Messonde (d.h. die Kugel 7 mit ihren Halbschleifen und ihrem gesamten Innenleben) elektrisch vollständig isoliert sind von weiteren externen Messgeräten. Es darf keine leitende Verbindungen (wie z.B. ein Koaxialkabel) mit der Umwelt geben. Dadurch werden nicht nur gefährliche Induktionsschleifen, sondern auch störende Einflüsse auf das Messfeld vermieden.

Der Messrechner 12, der vorzugsweise ein portabler Computer ist, kann in grosser Entfernung (z.B. 100 - 1000 m) vom Messort entfernt aufgestellt werden, wo die Gefahr einer durch das starke Messfeld (z.B. Nahfeld einer Sendeantenne) bedingten Störung gering ist. Er kann z.B. Messreihen aufnehmen (abspeichern) und auswerten.

Die elektronische Schaltung 8 muss messtechnisch gesehen hohe Anforderungen erfüllen. Bei einem bevorzugten Messbereich von 75 kHz - 30 MHz empfiehlt sich ein Kugeldurchmesser von ca 15 cm. Die Elektronik muss also ziemlich klein und verlustarm sein. Wenn Feldstärken im Bereich von 10 - 1200 V/m (ca. 40 dB) gemessen werden sollen, dann ist aufgrund der induktiven Charakteristik der Schleifenantenne (20 dB pro Dekade) mit einem Dynamikbereich von ca. 92 dB zu rechnen. Angesichts der kleinen minimalen Signalpegel (ca. 56 $\mu$V) müssen die Signale aktiv verstärkt werden. Schliesslich ist eine Messgenauigkeit von z.B. 10 % (1 dB) gewünscht. Es ist somit klar, dass man mit konventionellen aktiven Verstärkern nicht zum Ziel gelangt.

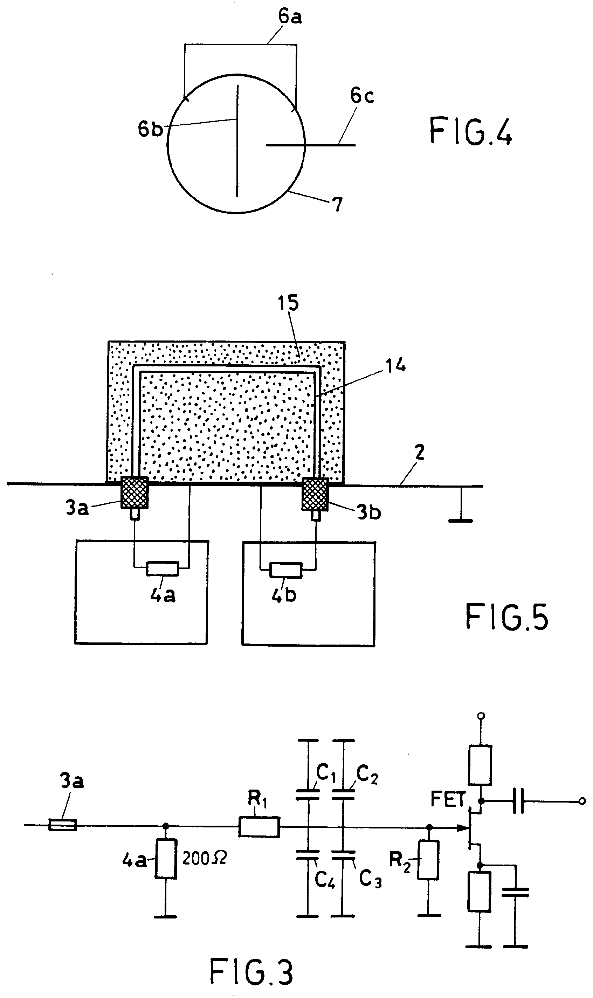

Fig. 3 zeigt nun eine bevorzugte Ausführungsform einer Schaltung zum Abgreifen einer Spannung $V_1$ resp. $V_2$ am Lastwiderstand 4a resp. 4b. Es handelt sich dabei um einen Tiefpass erster Ordnung in Form eines hochohmigen passiven RC-Gliedes. Masse (Ground) ist für diese Schaltung die Kugel 7. Im vorliegenden Beispiel hat der Lastwiderstand 4a den bevorzugten Wert von 200 Ohm.

Zwischen der Koaxialdurchführung 3a und dem Lastwiderstand 4a ist ein Widerstand $R_1$ (z.B. 10 kOhm) angehängt. Dieser ist im Verhältnis zum Lastwiderstand so gross, dass die Eingangsimpedanz im wesentlichen nicht geändert wird. Vorzugsweise ist $R_1$ mindestens 10 Mal grösser als die Last.

Das C-Glied des Tiefpasses umfasst mehrere, parallel geschaltete Kapazitäten $C_1$, ..., $C_4$ (z.B. 4 Chipkondensatoren zwischen 50 und 100 pF). Es hat sich nämlich gezeigt, dass bei Verwendung eines einzigen, relativ grossen Chipkondensators eine Resonanz bei etwa 100 MHz auftritt, die den Frequenzgang bis hinunter zu 30 MHz störend beeinflusst. Dies kann durch die beschriebene Aufteilung vermieden werden. Es sind zwar auf dem Markt auch sog. Durchführungskondensatoren erhältlich, die eine viel höhere Resonanzfrequenz haben als die Chipkondensatoren und von daher geeigneter erscheinen. Allerdings sind sie nicht nur relativ gross und teuer, sondern zeigen auch eine stärkere Temperaturabhängigkeit als die Chipkondensatoren.

Damit der Tiefpass nicht zu stark belastet und damit seine untere Grenzfrequenz unerwünschterweise angehoben wird, weist die erste, an den Tiefpass anschliessende Verstärkerstufe vorzugsweise einen Feldeffekttransistor (FET: z.B. Junction-FET) auf, der nicht nur einen hohen Eingangswiderstand (> 1 MOhm), sondern auch hervorragende Rauscheigenschaften bei tiefen Frequenzen (< 100 kHz) hat.

Die weitere Signalaufbereitung richtet sich nach den Bedürfnissen des Anwenders und den Möglichkeiten der Stromversorgung (Akkumulator) und bereitet keine unüberwindbaren Schwierigkeiten.

Der grosse Vorteil der kugelförmigen Messonde liegt darin, dass sie erlaubt, sowohl E- als auch H-Feld gleichzeitig und dreidimensional zu ermitteln. Zu diesem Zweck sind aussen an der Kugel 7 drei paarweise orthogonale Halbschleifen 6a, 6b, 6c angeordnet (Fig. 4). Jede der drei Halbschleifen 6a, 6b, 6c bildet zusammen mit der Kugel 7 eine Schleifenantenne, die die ihr zugeordneten Komponenten des E- und H-Feldes detektiert.

Die Schaltung 8 verarbeitet gleichzeitig nicht nur zwei, sondern sechs Spannungen (zwei pro Richtung) und übermittelt diese via Optolink an den Messrechner.

Die Erfindung eignet sich natürlich nicht nur zum Messen von komplexen Nahfeldern im freien Raum, sondern auch zum Messen von Feldern in Wellenleitern wie z.B. der aus der Patentschrift EP-0,246,544 bekannten TEM-Zelle mit pyramidenförmig sich aufweitendem Aussenleiter. Eine bevorzugte Ausführungsform, die sich durch ihre Robustheit auszeichnet, wird im folgenden beschrieben.

Fig. 5 zeigt eine schematische Darstellung einer Halbschleife in der Form einer aufgedruckten Leiterbahn 14. Als Träger kann eine konventionelle isolierende Leiterplatte 15 dienen. Im Fall einer TEM-Zellenmessung wird die Metallfläche 2 durch den (geerdeten) Aussenleiter der TEM-Zelle gebildet, wobei sich die Halbschleife natürlich im Innern der TEM-Zelle, die Schaltung aber aussen befindet. Koaxialdurchführungen 3a, 3b, Lastwiderstände 4a, 4b sowie die ganze Auswerteelektronik sind im Prinzip wie oben beschrieben ausgeführt. Insbesondere gelten die Ausführungen bezüglich der Form und der Fläche der Halbschleife sinngemäss für die Leiterbahtn 14. Im Gegensatz zur Kugelsonde, sind die Platzprobleme bei TEM-Zellenmessungen unter Benützung des Aussenleiters als Metallfläche natürlich nicht vorhanden.

Aus den oben gemachten Ausführungen geht hervor, dass die Halbschleife drahtförmig sein soll. Damit ist gemeint, dass sie die Form eines zu einem Halbkreis, -quadrat, -oktagon etc. gekrümmten, langen dünnen Stabs hat. Der Stabquerschnitt soll also viel (z.B. 10 bis 100 Mal) kleiner als der Durchmesser des geformten Halbkreises (resp. -quadrats, -oktagons etc.) sein. Der Begriff "Draht" ist somit in der weitest denkbaren Art (d.h. als langes dünnes Gebilde aus einem geeigneten Material) auszulegen und beschränkt sich keinesfalls auf Kupfer- oder Metalldraht.

Durch eine geeignete Wahl des Materials kann die Breitbandigkeit der Schleifenantenne ohne Reduktion des Schleifendurchmessers erhöht werden. Dies lässt sich durch Verwendung eines Materials erreichen, das mit einem gewissen Verlust behaftet ist. Anstelle einer metallenen Halbschleife kann in diesem Sinn z.B. eine solche aus Graphit oder einem (ev. dotierten) Halbleitermaterial eingesetzt werden.

Eine Verfeinerung dieses Prinzips ergibt bei einer Halbschleife mit ortsabhängigem Widerstand. Dort wo der Strom im Mittel am grössten ist, wird ein höherer Widerstandswert vorgesehen als den Stellen geringen Stroms. Ziel der ortsangepassten Widerstandsbemessung soll es sein, eine möglichst konstante Stromverteilung auf der Halbschleife zu erreichen. Sobald nämlich Resonanzen auftreten, verschwindet die gewünschte Linearität der Antennenkennlinie. Ein weiterer Vorteil dürfte sich daraus ergeben, dass bei vorgegebener oberer Grenzfrequenz die Signalpegel allgemein höher sind als bei einer einfachen Metallhalbschleife. Aufgrund der Dämpfungsmittel darf der Schleifendurchmesser nämlich grösser sein als im ungedämpften Fall, da die Schleife weniger schnell in den Resonanzbereich und damit in den nicht linearen Frequenzbereich gerät.

Der variable Widerstand lässt sich z.B. durch einen beschichteten Draht realisieren, wobei sich der örtliche Widerstandswert durch die Dicke der Beschichtung (z.B. Metallegierung) einstellen lässt. Es ist offensichtlich, dass der erhöhte oder sogar lokal angepasste Widerstand ohne weiteres auch bei der beschichteten Leiterplatte (Fig. 5) verwirklichen lässt.

Zusammenfassend kann folgendes festgestellt werden: Die Erfindung hat die Grundlagen zur Realisierung eines neuartigen Feldstärkenmessgeräts geschaffen, mit dem der gesamte Lang-, Mittel- und Kurzwellenbereich (75 kHz bis 30 MHz) mit hoher Messgenauigkeit abgedeckt werden kann. Zum ersten Mal ist es möglich, elektrisches und magnetisches Feld gleichzeitig und dreidimensional mit nur einer Messonde zu erfassen und infolgedessen Nahfelder zu charakterisieren. Die kostenintensive Messzeit wird allein schon durch die gleichzeitige Messung von E- und H-Feld um mindestens 50 % verkürzt. Die Möglichkeit der computerisierten Steuerung erlaubt fehlerfreien und feldtauglichen Einsatz auch unter erschwerten Bedingungen. Bei sehr hohen Feldstärken wird ausserdem ein optimaler Personenschutz gewährleistet, da die Messdaten ohne weiteres per Glasfaserkabel bis zu 1000 m vom Ort des Sensors übertragen werden können.

**Bezeichnungsliste**

1, 5, 6a, 6b, 6c - Halbschleife; 2 - Metallfläche; 3a, 3b - Koaxialdurchführungen; 4a, 4b - Lastwiderstand; 7 - Kugel; 8 - Schaltung; 9 - Sender; 10 - Glasfaserkabel; 11 - Empfänger; 12 - Messrechner; 13 - Akkumulator; 14 - Leiterbahn; 15 - Leiterplatte.

**Patentansprüche**

1. Feldstärkenmessgerät mit einer zum gleichzeitigen Detektieren von E- und H-Feldern geeigneten Schleifenantenne, welche durch zwei an gegenüberliegenden Seiten der Schleifenantenne angeordnete Lastwiderstände (4a, 4b) in eine erste und eine zweite Halbschleife (1, 5) aufgetrennt ist, und mit einer Schaltung (8) zum Ermitteln der Feldstärken der E- und H-Felder anhand der an den Lastwiderständen (4a, 4b) gemessenen Spannungen (V1, V2), dadurch gekennzeichnet, dass die erste Halbschleife (1) beidseitig durch eine Metallfläche (2) hindurchgeführt ist und über Lastwiderstände (4a, 4b) an die Metallfläche (2) angeschlossen ist, so dass die erste Halbschleife (1) mit ihrem feldtheoretisch durch die Metallfläche (2) erzeugten, die zweite Halbschleife (5) ersetzenden Spiegelbild eine geschlossene Schleifenantenne bildet, und dass die Schaltung (8) in einem durch die Metallfläche (2) gegenüber der ersten Halbschleife (1) abgeschirmten Teilraum angeordnet ist.

2. Feldstärkenmessgerät nach Anspruch 1, dadurch gekennzeichnet, dass die Metallfläche (2) eine gekrümmte, in sich geschlossene Fläche bildet, die den abgeschirmten Teilraum allseitig umschliesst.

3. Feldstärkenmessgerät nach Anspruch 1, dadurch gekennzeichnet, dass die erste Halbschleife im wesentlichen einen Teilabschnitt eines Kreises resp. eines regulären Polygons bildet.

4. Feldstärkenmessgerät nach Anspruch 1, dadurch gekennzeichnet, dass die zwei Lastwiderstände (4a, 4b) im wesentlichen gleich gross sind und zwischen 50 und 1000 Ohm, insbesondere zwischen 100 und 300 Ohm liegen.

5. Feldstärkenmessgerät nach Anspruch 1, dadurch gekennzeichnet, dass zum Abgreifen der an den Lastwiderständen (4a, 4b) anliegenden Spannungen ($V_1$, $V_2$) jeweils ein Tiefpass erster Ordnung mit einem gegenüber dem Lastwiderstand (4a) grossen Eingangswiderstand ($R_1$) und einem in mehrere parallele Teilkapazitäten ($C_1$,...,$C_4$) aufgeteilten C-Glied vorgesehen ist.

6. Feldstärkenmessgerät nach Anspruch 1, dadurch gekennzeichnet, dass die Metallfläche (2) als Kugelfläche ausgebildet ist und dass drei paarweise orthogonal ausgerichtete gleiche Halbschleifen (6a, 6b, 6c) auf der Kugelfläche angeordnet sind, so dass E- und H-Feld gleichzeitig vektoriell bestimmt werden können.

7. Feldstärkenmessgerät nach Anspruch 6, dadurch gekennzeichnet, dass die Halbschleifen (6a, 6b, 6c) je eine Fläche einschliessen, die nicht grösser als der halbe Wirkungsquerschnitt der Kugelfläche ist und dass der Kugeldurchmesser kleiner als die Hälfte, insbesondere kleiner oder gleich einem Zehntel der kleinsten zu messenden Wellenlänge des E- resp. H-Feldes ist.

8. Feldstärkenmessgerät nach Anspruch 1, dadurch gekennzeichnet, dass die erste Halbschleife (6a, 6b, 6c) drahtförmig ist und einen Durchmesser von mehr als 0.1 mm, insbesondere von mindestens 1 mm hat.

9. Feldstärkenmessgerät nach Anspruch 1, dadurch gekennzeichnet, dass die erste Halbschleife (1) eine auf eine isolierende Leiterplatte (15) aufgebrachte Leiterbahn (14) ist.

10. Feldstärkenmessgerät nach Anspruch 1, dadurch gekennzeichnet, dass die erste Halbschleife (1; 6a, 6b, 6c)im wesentlichen die Hälfte eines Quadrats bildet.

**Claims**

1. Field strength measuring instrument comprising a loop antenna which is suitable for the simultaneous detection of E and H fields and which is divided into a first and a second half-loop (1,5) by two load resistors (4a, 4b) arranged at opposite ends of the loop antenna, and comprising a circuit (8) for determining the field strengths of the E and H fields by means of the voltages (V1, V2) measured across the load resistors (4a, 4b), characterized in that the first half-loop is conducted through a metal surface (2) on both sides and is connected to the metal surface (2) via load resistors (4a, 4b) so that the first half-loop (1), together with its mirror image generated by the metal surface (2) in accordance with field theory and replacing the second half-loop (5), forms a closed loop antenna, and in that the circuit (8) is arranged in a part-space shielded from the first half-loop (1) in that by the metal surface (2).

2. Field strength measuring instrument according to Claim 1, characterized in that the metal surface (2) forms a curved surface closed in itself, which encloses the shielded part-space on all sides.

3. Field strength measuring instrument according to Claim 1, characterized in that the first half-loop essentially forms a part-section of a circle or of a regular polygon.

4. Field strength measuring instrument according to Claim 1, characterized in that the two load resistors (4a, 4b) are essentially of the same size and have resistances of between 50 and 1000 ohms, particularly between 100 and 300 ohms.

5. Field strength measuring instrument according to Claim 1, characterized in that in each case one first-order low-pass filter with an input impedance (R1) which is large compared with the load resistance (4a) and a C section divided into a plurality of parallel part-capacitors ($C_1$,..., $C_4$) is provided for picking off the voltages (V1, V2) present across the load resistors (4a, 4b).

6. Field strength measuring instrument according to Claim 1, characterized in that the metal surface (2) is constructed as spherical surface and in that three identical half-loops (6a, 6b, 6c) which are orthogonally aligned in pairs, are arranged on the spherical surface so that E and H field can be vectorially determined at the same time.

7. Field strength measuring instrument according to Claim 6, characterized in that the half-loops (6a, 6b, 6c) each enclose an area which is not larger than half the effective cross-section of the area of the sphere, and in that the diameter of the sphere is smaller than half, especially less than or equal to one tenth, of the smallest wavelength of the E or H field to be measured.

8. Field strength measuring instrument according to Claim 1, characterized in that the first half-loop (6a, 6b, 6c) is wire-shaped and has a diameter of more than 0.1 mm, particularly of at least 1 mm.

9. Field strength measuring instrument according to Claim 1, characterized in that the first half-loop (1) is a conductor track (14) applied to an insulating circuit board (15).

10. Field strength measuring instrument according to Claim 1, characterized in that the first half-loop (1; 6a, 6b, 6c) essentially forms one half of a square.


**Revendications**

1. Dispositif pour la mesure d'un champ muni d'une antenne cadre appropriée pour la détection simultanée des champs E et H, laquelle est séparée en un premier et un deuxième demi-cadre (1, 5) par deux résistances de charge (4a, 4b) disposées sur des côtés opposés de l'antenne cadre, et avec un circuit (8) destiné à déterminer les intensités de champ du champ E et H au moyen des tensions ($V_1$, $V_2$) mesurées aux bornes des résistances de charge (4a, 4b), caractérisé par le fait que le premier demi-cadre (1) traverse des deux côtés une surface métallique (2) et est raccordé à la surface métallique (2) par des résistances de charge (4a, 4b), de telle façon que le premier demi-cadre (1) avec son champ théorique formé par la surface métallique (2) forme l'image réfléchie qui remplace le deuxième demi-cadre (5) d'une antenne cadre fermée, et que le circuit (8) est logé dans un espace partiel blindé par rapport au premier demi-cadre (1) à l'aide de la surface métallique (2).

2. Dispositif pour la mesure d'un champ conforme à la revendication 1, caractérisé par le fait que la surface métallique (2) forme une surface curviligne refermée sur elle-même qui renferme l'espace partiel blindé.

3. Dispositif pour la mesure d'un champ conforme à la revendication 1, caractérisé par le fait que le premier demi-cadre forme pour l'essentiel un section partielle d'un cercle et respectivement d'un polygone régulier.

4. Dispositif pour la mesure d'un champ conforme à la revendication 1, caractérisé par le fait que les deux résistances de charge (4a, 4b) sont pour l'essentiel de même valeur et sont comprises entre 50 et 1000 ohms, notamment entre 100 et 300 ohms.

5. Dispositif pour la mesure d'un champ conforme à la revendication 1, caractérisé par le fait que pour prélever les tensions ($V_1$, $V_2$) présentes aux bornes des résistances de charge (4a, 4b) est prévu à chaque fois un filtre passe-bas du premier ordre avec une résistance d'entrée ($R_1$) grande par rapport à la résistance de charge (4a) et un condensateur partagé en plusieurs capacités partielles ($C_1$, ..., $C_4$).

6. Dispositif pour la mesure d'un champ conforme à la revendication 1, caractérisé par le fait que la surface métallique (2) est formée par une surface sphérique et que trois demi-cadres (6a, 6b, 6c) identiques sont disposés par paires orthogonales sur la surface de la sphère de telle façon que les champs E et H puissent être déterminés de façon simultanée et vectorielle.

7. Dispositif pour la mesure d'un champ conforme à la revendication 6, caractérisé par le fait que les demi-cadres (6a, 6b, 6c) renferment à chaque fois une surface qui n'est pas plus grande que la moitié de la section efficace de diffusion de la surface sphérique et que le diamètre de la sphère est inférieur à la moitié, notamment inférieur ou égal à un dixième de la plus petite longueur d'onde à mesurer des champs E et H respectifs.

8. Dispositif pour la mesure d'un champ conforme à la revendication 1, caractérisé par le fait que le premier demi-cadre (6a, 6b, 6c) est filiforme et a un diamètre supérieur à 0,1 mm, notamment au moins de 1 mm.

9. Dispositif pour la mesure d'un champ conforme à la revendication 1, caractérisé par le fait que le premier demi-cadre (1) est une piste conductrice (14) montée sur une plaque conductrice (15) isolée.

10. Dispositif pour la mesure d'un champ conforme à la revendication 1, caractérisé par le fait que le premier demi-cadre (1 ; 6a, 6b, 6c) forme pour l'essentiel la moitié d'un carré.

FIG.1a

FIG.1b

FIG.2

FIG.4

FIG.5

FIG.3